# EUROPÄISCHE PATENTSCHRIFT

(11) **EP 1 416 614 B1**
(45) Veröffentlichungstag und Bekanntmachung des Hinweises auf die Patenterteilung: **14.06.2006**
(21) Anmeldenummer: 03103802.9
(22) Anmeldetag: 15.10.2003
(51) Int. Cl.: H02K 5/22

(54) **Anschlussadapter für einen Elektromotor**
Connection adapter for electric motor
Raccord adapter pour un moteur électrique

(30) Priorität: 04.11.2002 DE 10251226
(43) Veröffentlichungstag der Anmeldung: 06.05.2004
(73) Patentinhaber: SIEMENS AKTIENGESELLSCHAFT, 80333 München (DE)
(72) Erfinder: Göb, Werner, 97273, Kürnach (DE); Volz, Christian, 64291, Darmstadt (DE)

(56) Entgegenhaltungen:
- EP-A- 0 655 822
- EP-A- 1 037 364
- EP-A- 1 120 885
- DE-A- 4 226 509
- DE-A- 10 008 671
- US-A- 2 230 581
- US-A- 4 233 531
- US-A- 5 986 367
- PATENT ABSTRACTS OF JAPAN vol. 2000, no. 16, 8. Mai 2001 (2001-05-08) & JP 2001 008400 A (AKEBONO BRAKE IND CO LTD), 12. Januar 2001 (2001-01-12)

## Beschreibung

Die Erfindung bezieht sich auf einen Anschlussadapter für einen Elektromotor gemäß Anspruch 1.

Der Anschlussadapter wird verwendet in Verbindung mit Elektromotoren, wie sie in der Automobiltechnik zum Antrieb von Lüftergebläsen, Fensterhebern, Schiebedächern, Hydraulik-Aggregaten und ähnlichen Systemen eingesetzt werden.

Der Anschlussadapter kann dabei die Funktion der elektrischen Kontaktierung und gleichzeitig die Funktion der mechanischen Schnittstelle zwischen Elektromotor und Einbauumgebung in sich vereinigen.

Aus der EP 0 848 477 B1 ist eine geräuschgedämmte Halterung eines Elektromotors bekannt. Diese wird verwendet zur Geräuschdämmung und gleichzeitig zur mechanischen Halterung zwischen einem Elektromotor und einem äußeren Motor-Halterungsteil. Diese Halterung wird insbesondere verwendet in Verbindung mit einem Elektromotor zum Antrieb eines Lüftergebläses in einem Kraftfahrzeug. Diese geräuschgedämmte Halterung weist ein in gegenseitiger Betriebsendlage vormontiertes Adapterteil auf.

Dieses Adapterteil nimmt den Elektromotor durch axiales Einstecken des Elektromotors lagefixiert in sich auf und bildet mittelbar über geräuschdämmende Zwischenteile die mechanische Verbindung zwischen Elektromotor und einem radial äußeren Motorhalterungsteil. Für die elektrische Kontaktierung des Elektromotors werden weitere Bauteile und Montageschritte erforderlich, wobei die elektrischen Anschlussleitungen in aufwändiger Weise durch die beschriebenen Adapter- und Motorhalterungsteile hindurch oder aus diesen herausgeführt werden müssen.

Aus der DE 34 34 429 C2 ist dagegen ein entstörter Kommutator-Motor bekannt, der ein sogenanntes Zwischenklemmbrett aufweist, das als zentrale Anschlusseinheit mit mechanisch fixierten und elektrisch verbundenen äußeren Anschlussleitungen, Zwischenleitungen zum Anschluss an die Entstördrosseln des Elektromotors sowie einem Kondensator versehen ist. Das Zwischenklemmbrett wird durch einfache Rasthalterungen am Motor befestigt. Zur geräuschdämmenden Entkopplung und zur Anpassung der mechanischen Schnittstellen zur Montage des Elektromotors in seinem Einbauraum ist hier jedoch ein separater Adapter erforderlich, da das Zwischenklemmbrett diese Funktion nicht übernehmen kann. Weiterhin besteht der Nachteil, dass das Zwischenklemmbrett aufgrund seiner flexiblen Anschlussleitungen nicht einfach automatisiert mit dem Elektromotor einerseits und mit äußeren Anschlüssen andererseits elektrisch kontaktiert werden kann.

Weiterhin ist aus dem Dokument EP 0 504 469 A1 eine elektrische Kontaktverbindung, insbesondere Massekontaktverbindung zum Potentialausgleich für einen funkentstörten Kraftfahrzeug-Motorhilfsantrieb bekannt. Zur Herstellung dieser Kontaktverbindung wird eine zusätzliche Kontaktklemme vorgeschlagen, die den Kontakt zwischen der Litze der Minusleitung und dem Motorgehäuse herstellt. Auch die EP 1 037 364 A1 offenbart einen Massekontakt am Motorgehäuse, der mit Hilfe eines im Motor-Lagerschild (end cap) eingelegten Kontaktteils (negative terminal) hergestellt ist. Die Masseverbindung dient insbesondere dem zu einer vollkommenen Funkentstörung notwendigen Potentialausgleich zwischen der Masse der Kraftfahrzeug-Karosserie und dem Motorgehäuse einerseits und der Minusleitung zur Kraftfahrzeug-Batterie andererseits.

Aus der Zusammenfassung der japanischen Patentanmeldung JP 2001 008400 ist ein Gehäuse für einen Elektromotor bekannt, das mit einem Sockel ausgestattet ist, der zur Aufnahme der am Motor angeordneten Steckkontakte zur Stromversorgung des Motors vorgesehen ist. Der Sockel ist über im Gehäuse angeordnete elektrische Leitungen mit auf der Außenseite des Gehäuses angeordneten Anschlusskontakten verbunden. Dieses japanische Dokument ist als nächstliegender Stand der Technik anzusehen. Eine Massekontaktverbindung, wie aus der EP 0 504 469 bekannt,ist in dem japanischen Dokument weder offenbart noch wird ein Hinweis darauf gegeben wie eine solche Massekontaktverbindung auf besonders einfache Weise ausgeführt werden kann.

Die DE 42 26 509 A1 zeigt einen Anschlussadapter für den elektrischen Kleinmotor einer Zentralverriegelung eines Kraftfahrzeuges. Im Adapter sind Kontaktfahnen vorgesehen, die Steckerbuchsen des Kleinmotors kontaktieren.

Der vorliegenden Erfindung liegt die Aufgabe zugrunde, einen Anschlussadapter für einen Elektromotor zu schaffen, mit dessen Hilfe es möglich ist, die elektrische Kontaktierung des Motors montagetechnisch zu vereinfachen. Dabei soll der Anschlussadapter gleichzeitig als mechanische Schnittstelle zwischen Elektromotor und dessen Einbauraum dienen können.

Diese Aufgabe wird gelöst durch einen erfindungsgemäßen Anschlussadapter für einen ein Metallgehäuse aufweisenden Elektromotor, mit einem Trägerbauteil aus elektrisch isolierendem Werkstoff. Das Trägerbauteil umfasst das Metallgehäuse des Elektromotors radial zumindest teilweise und nimmt den Elektromotor form- und/oder kraftschlüssig Lagefixiert auf. Im oder am Trägerbauteil ist mindestens eine elektrische Anschlussleitung befestigt, die Lagefixierte Kontaktstellen, zum Kontaktieren des Elektromotors einerseits und zum Kontaktieren externer elektrischer Anschlüsse andererseits aufweist. Dabei steht eine Anschlussleitung sowohl mit einem Motorkontakt einer Bürstenanordnung des Elektromotors als auch über eine weitere Kontaktstelle (3.3) mit dem Metallgehäuse des Elektromotors unmittelbar in parallelem elektrischen Kontakt, wobei der zur Herstellung des elektrischen Kontaktes erforderliche Kontaktdruck unter Nutzung der elastischen Verformbarkeit des Trägerbauteils und der Anschlussleitung erzeugt ist.

Die Erfindung hat die Vorteile einer reduzierten Teileanzahl in der Endmontage bei gleichzeitiger handhabungs- und montagegerechter Gestaltung der Einzelteile.
Durch die positionsstabilen Kontaktstellen wird eine einfache und damit kostengünstige Automatisierung der Kontaktierungsvorgänge ermöglicht und die gesamte elektrische Kontaktierung des Elektromotors lässt sich in einem einfachen Montagevorgang herstellen.
Diese Vorteile ermöglichen eine einfache und wirtschaftliche Automatisierung der Handhabungs- und Montagevorgänge in der Produktion, was vor allem in der Großserienproduktion erhebliche Vorteile in Bezug auf die Qualität und Kosten aufweist.

Die Anschlussleitungen des Anschlussadapters können in verschiedener zweckdienlicher Weise ausgeführt werden. Es können beispielsweise vorgeformte formstabile Drahtbiegeteile oder Stanz-Biegeteile Verwendung finden.

Vorteilhafte Ausgestaltungen des Anschlussadapters sind jeweils Gegenstand der Unteransprüche.

Es besteht die zusätzliche Möglichkeit bestimmte Kontaktierungsmittel an den Kontaktstellen vorzusehen, wie zum Beispiel Schneid-Klemmkontakte, Steckkontakte oder Federkontakte. Diese ermöglichen ein zwangsmäßiges Kontaktieren beim Einstecken des Elektromotors in den Anschlussadapter oder/und dem Einbau des Elektromotors zusammen mit dem Anschlussadapter in den vorgesehenen Einbauraum.

Eine weitere vorteilhafte Möglichkeit, die durch die Erfindung gegeben ist, ist die Aufnahme zusätzlicher elektrischer Bauteile in den Anschlussadapter und die unmittelbare Kontak tierung dieser Bauteile mit Kontaktstellen der Anschlussleitungen. Solche Bauteile dienen zum Beispiel zur Funkentstörung, Temperatur-Absicherung oder auch zur elektronischen Ansteuerung des Elektromotors. Durch zusätzliche Ausformungen des Trägerbauteils können diese elektrischen Bauteile mechanisch am Trägerbauteil befestigt oder auch zumindest teilweise umschlossen oder abgedeckt werden, um sie vor Umgebungseinflüssen zu schützen.

Die Ausführung des Trägerbauteils kann unterschiedliche Mittel zur mechanischen Befestigung der Elektromotor-Anschlussadapter-Baugruppe im jeweiligen Einbauraum aufweisen, wie zum Beispiel Stege, Rippen, Laschen, Ösen, Nuten, Zapfen, Füße, Flansche, eingeformte Gewinde oder eingebettete Gewindebuchsen, etc.
Auch die Umfassung des Elektromotors durch das Trägerbauteil des Anschlussadapters kann variieren von nur teilweise radial über zylinderförmig und topfförmig bis zum geschlossenen Gehäuse, wo zumindest eine Stirnseite des Elektromotors vom Anschlussadapter topfförmig mit eingeschlossen ist.

So besteht die Möglichkeit zur Anpassung der Außenkontur des Elektromotors an seinen jeweiligen Einbauraum und gleichzeitig den Elektromotor zumindest einseitig gegen Umgebungseinflüsse abzuschirmen oder abzudichten.

Diese vielfältigen Gestaltungsmöglichkeiten bieten den Vorteil der flexiblen Anpassbarkeit der Ausführung des Anschlussadapters an die vielfältigen und unterschiedlichen Anforderungen der verschiedenen Einsatzbereiche der Elektromotoren und an die produktionstechnischen Anforderungen. Dies vereinfacht die kunden- oder anwendungsspezifische Anpassung von Standard-Elektromotoren die dadurch kostengünstig in großen Stückzahlen produziert werden können.

Vorteilhafte Ausführungsbeispiele der Erfindung werden im Folgenden anhand der schematischen Zeichnung näher erläutert; in perspektivischer Darstellung zeigen darin:
- Figur 1: eine Ansicht eines Elektromotors mit einem erfindungsgemäßen Anschlussadapter, bei dem Anschlussleitungen als vorgeformte Drahtbauteile in Nuten und Raststützpunkten eines Trägerbauteils lagefixiert sind;
- Figur 2: ein weiteres Ausführungsbeispiel des Anschlussadapters mit im Adapterwerkstoff eingespritzten Anschlussleitungen und mit verschiedenen Kontaktierungsmitteln, ohne Elektromotor;
- Figur 3: ein weiteres Ausführungsbeispiel des Anschlussadapters das nicht unter den Gegenstand der vorliegenden Ansprüche fällt, mit Leiterbahnen, die auf die Oberfläche des Trägerbauteils aufgalvanisiert oder als elektrisch leitfähige Folie aufgeklebt sind;
- Figuren 4A und 4B: jeweils in einer Ausschnittsansicht ein typisches Beispiel einer Rastverbindung zwischen Trägerbauteil und Draht-Anschlussleitung, vor bzw. nach dem Einrasten der Draht-Anschlussleitung;
- Figuren 5A und 5B: jeweils in einer Ausschnittsansicht ein Beispiel der Lagefixierung der Anschlussleitung, hier als Blech-Stanzteil, durch Einlegen und nachträgliches Umformen spezieller, dafür vorgesehener Ausformungen am Trägerbauteil, vor bzw. nach dem Fixieren der Anschlussleitung;
- Figuren 6A und 6B: jeweils eine Ansicht von Anschlussleitungen, die als einteiliges Stanz-Biege-Formteil ausgeführt sind und die durch Auftrennen einer Trennstelle elektrisch von einander getrennt werden, bzw. nach dem Auftrennen der Trennstelle; und
- Figuren 7A und 7B: jeweils eine Ausschnittsansicht einer Ausführung der Kontaktierung und mechanischen Befestigung von zusätzlichen elektrischen Bauteilen, hier eines Widerstandes, zwischen zwei Kontaktstellen der Anschlussleitungen.

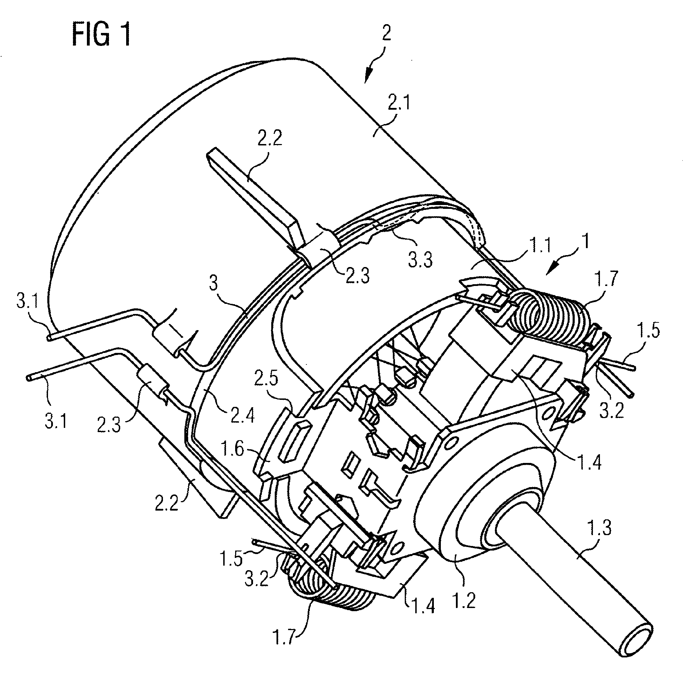

Figur 1 zeigt einen Elektromotor 1 bestehend aus dem Metallgehäuse 1.1, einem Lagerschild 1.2, einer Motorwelle 1.3 und Bürstenhaltern 1.4 mit Motorkontakten 1.5 an den elektrischen Drosselbauteilen 1.7.
Der Elektromotor 1 ist ein typischer Gleichstrom-KommutatorMotor in sogenannter Open-Frame-Bauweise, wie er in Lüftergebläsen in Kraftfahrzeugen häufig verwendet wird. Das Metallgehäuse 1.1 ist als einfacher Metall-Zylindermantel ausgebildet und beidseitig offen.

Der Elektromotor 1 steckt in einem Anschlussadapter 2, der das Metallgehäuse 1.1 radial umfasst. Der Anschlussadapter 2 besteht aus einem Trägerbauteil 2.1, das auf seiner Außenseite Mittel zur Fixierung im Einbauraum 2.2, Raststützpunkte 2.3 und eine Leitungsnut 2.4 aufweist. Der Elektromotor ragt mit Laschen 1.6 des Lagerschildes 1.2 in gegengleiche Aussparungen 2.5 des Trägerbauteils hinein. In der Leitungsnut 2.4 sind Anschlussleitungen 3 mit Kontaktstellen 3.1 zur Kontaktierung externer Anschlüsse, Kontaktstellen 3.2 zur Kontaktierung der Motorkontakte 1.5 und einem Massekontakt 3.3 durch die Raststützpunkte 2.3 lagefixiert geführt.

Vorzugsweise wird der Elektromotor 1 axial in den Anschlussadapter 2 eingesteckt und durch Einrasten oder maßliche Abstimmung in form- und/oder kraftschlüssige mechanische Verbindung mit dem Trägerbauteil 2.1 gebracht. Das Trägerbauteil ist vorzugsweise aus thermoplastischem Kunststoff im Spritzgussverfahren hergestellt.

Durch geringfügige Unter-Dimensionierung des lichten Innendurchmessers des Trägerbauteils 2.1 in Relation zum Außendurchmesser des Metallgehäuses 1.1 entsteht eine Klemmwirkung, die eine kraftschlüssige Verbindung zwischen dem Anschlussadapter 2 und dem Elektromotor 1 herstellt.

Durch das Ineinandergreifen oder sogar einrasten von Aussparungen, Laschen, Absätzen, etc. von Trägerbauteil 2.1 und Elektromotor 1 wird zusätzlich ein Formschluss zwischen den beiden Komponenten erzeugt. Mit Hilfe der Mittel zur Fixierung 2.2 des Trägerbauteils 2.1 im umgebenden Einbauraum, hier als axial verlaufende Flügel dargestellt, wird die Baugruppe -Anschlussadapter und Elektromotor- zum Beispiel in einem Gebläsegehäuse gelagert, aufgehängt oder auf andere Weise befestigt (nicht dargestellt).

Durch die Verwendung von Kunststoff-Werkstoffen, insbesondere thermoplastischen Kunststoffen, für das Trägerbauteil 2.1, können durch Formgebung zum Beispiel im Spritzgussverfahren auch komplexe Außen- und Innenkonturen auf einfachem und kostengünstigen Weg realisiert werden.

So lassen sich die Außenkonturen eines Standard-Elektromotors auf spezielle Anforderungen des jeweils speziellen Einbauraumes bei zum Beispiel verschiedenen Kraftfahrzeug-Modellen leicht anpassen. In dieser Eigenschaft kann der Anschlussadapter 2.1 weitere Funktionen, wie zum Beispiel Schwingungs- und Geräuschentkopplung sowie, Abschirmung gegen Umgebungseinflüsse wahrnehmen.

Am Trägerbauteil 2.1 sind die elektrischen Anschlussleitungen 3 befestigt. Bei dem Ausführungsbeispiel nach Figur 1 handelt es sich um nachträglich montierte, vorgebogene, formstabile Metalldrähte, die in die Leitungsnut 2.4 des Trägerbauteils 2.1 eingelegt und mit Hilfe der Raststützpunkte 2.3 darin lagefixiert geführt werden.

Durch die mechanische Lagefixierung der Anschlussleitungen 3, und daran angepasste Ausgestaltungen des Trägerbauteils - vor allem im Bereich der vorgesehenen Kontaktstellen 3.1, 3.2, 3.3 der Anschlussleitungen- sowie zweckmäßige Auswahl des Werkstoffes der Anschlussleitungen 3 wird gewährleistet, dass auch die Kontaktstellen 3.1, 3.2, 3.3 in vorgegebener Position relativ zum Trägerbauteil und Elektromotor positionsstabil verharren.

Bei einer ausreichenden Anzahl der Raststützpunkte 2.3 und deren Positionierung entlang dem 3-dimensionalen Verlauf der Anschlussleitungen 3 kann auf die Führung der Anschlussleitungen 3 durch eine Leitungsnut 2.4 auch verzichtet werden. Die gezeigte Ausführung der Raststützpunkte 2.3 ist nur als beispielhaft zu verstehen und kann durch andere funktionell gleichwertige Ausformungen des Trägerbauteils 2.1 ersetzt werden.

Die Kontaktstellen 3.1, 3.2 sind bei dem Ausführungsbeispiel nach Figur 1 einfache nicht elektrisch isolierte Stellen der Anschlussleitungen, die zur elektrischen Kontaktierung zugänglich sind. Eine dauerhafte Kontaktierung der Kontaktstellen 3.2 des Anschlussadapters mit den Motorkontakten 1.5 kann in diesem Fall durch Verschweißen, Verlöten oder auch Verquetschen mit separaten Quetschverbindungshülsen erzeugt werden. In anderen Ausführungsformen können die Kontaktstellen 3.1, 3.2 bereits mit speziellen Kontaktierungsmitteln versehen oder als solche ausgebildet sein. Solche Kontaktierungsmittel sind beispielsweise Steckkontakte, Federkontakte, Kontaktfahnen, Kontaktflächen, Schneid-Klemm-Kontakte, Crimpkontakte oder auch spezielle Löt- oder Schweißstützpunkte.

Im Montageprozess gewährleistet die lagefixierte Position der formstabilen Anschlussleitungen 3 eine stabile relative Positionierung der Kontaktstellen 3.2 und der Motorkontakte 1.5. Dies ermöglicht einen einfach automatisierten Kontaktierungs vorgang im Montageablauf, bei bis in Montage-Endlage in den Anschlussadapter 2 eingestecktem Elektromotor 1.

Durch normalen fortschreitenden Bürstenverschleiß im Betrieb des Elektromotors können in dem in Figur 1 dargestellten Ausführungsbeispiel die Motorkontakte 1.5 von ihrer ursprünglichen Position fortschreitend und überwiegend in Umfangsrichtung des Elektromotors abweichen. Dies kann eine Verformung der Anschlussleitungen 3 im Bereich der Kontaktstellen 3.2 erzwingen. Die durch die Formstabilität der Anschlussleitungen 3 verursachten und über die Motorkontakte 1.5 auf die Bürstenhalter 1.4 übertragenen Reaktionskräfte können sich wiederum negativ auf die Funktion des Elektromotors auswirken. Um diesem Effekt entgegenzuwirken sind die Anschlussleitungen 3 im Bereich der Kontaktstellen 3.2 so auszulegen, dass die Reaktionskräfte auf vertretbar niedrigem Niveau bleiben.

Dies ist konstruktiv zum Beispiel zu gewährleisten durch Verformbarkeit der Anschlussleitungen 3 im elastischen Bereich, das heißt Federwirkung auf der umgeführten Länge der Anschlussleitungen 3 zwischen dem Trägerbauteil 2.1 und den Motorkontakten 1.5.

Ebenso ist es möglich den elektrischen Kontakt zwischen den Kontaktstellen 3.2 und den Motorkontakten 1.5 mit Hilfe eines zwischengeschalteten, flexiblen Leitungsstückes (nicht dargestellt), wie zum Beispiel einer Kupferlitze, herzustellen.

Eine weitere Kontaktstelle der elektrischen Anschlussleitung 3 stellt der Massekontakt 3.3 dar. Durch einen Durchbruch im Trägerbauteil im Bereich der Leitungsnut 2.4 ist eine formstabile Schleife einer Anschlussleitung 3 auf die Innenseite des Trägerbauteils 2.1 geführt. Diese Schleife ragt genau soweit in den lichten Durchmesser des Trägerbauteils 2.1 hinein, dass durch die axiale Einsteckmontage des Elektromotors 1 in den Anschlussadapter 2 die Kontaktstelle 3 mit Feder kraft auf das Metallgehäuse 1.1 des Elektromotors gedrückt und so ein elektrischer Kontakt zwangsweise herstellt wird. Zur Erzeugung des Kontaktdruckes wird dabei die elastische Verformbarkeit des Trägerbauteils 2.1 und der Anschlussleitung 3 ausgenutzt.

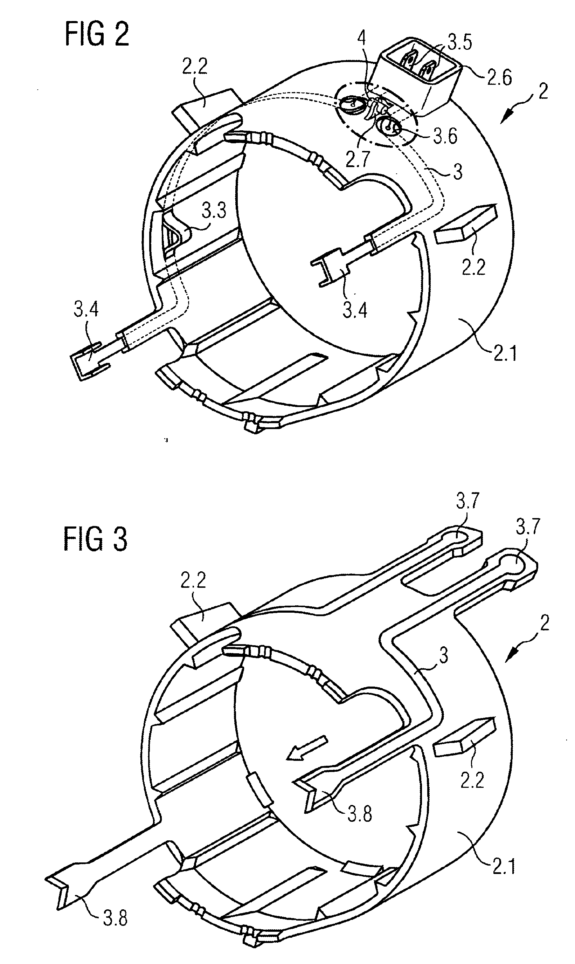

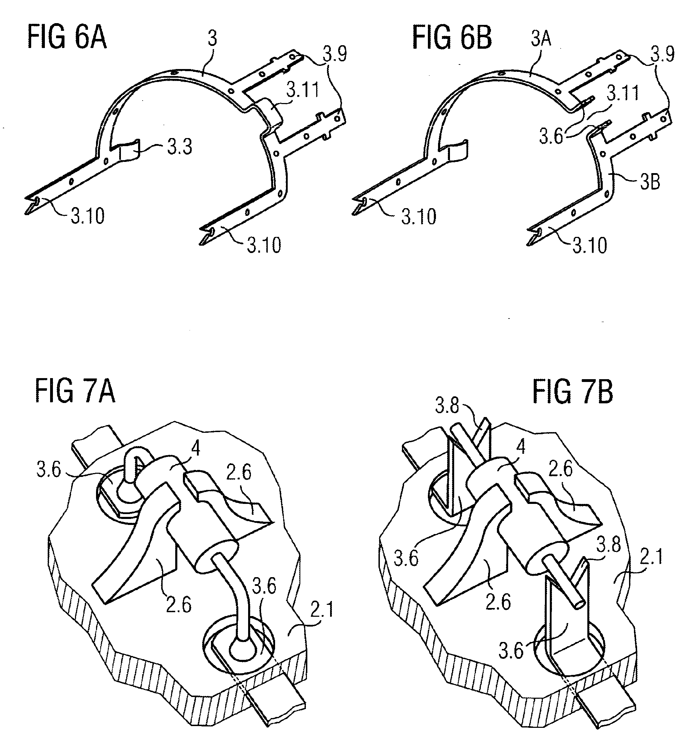

Figur 2 zeigt eine Ausführung des Anschlussadapters 2 ohne den Elektromotor. Bei diesem Ausführungsbeispiel ist das Trägerbauteil 2.1 aus elektrisch isolierendem thermoplastischen Kunststoff hergestellt und die elektrischen Anschlussleitungen sind als vorgeformte Stanz-/Biegeteile ausgeführt, wie sie auch in Figur 6 gezeigt werden. Diese Anschlussleitungen sind bis auf die definierten Kontaktstellen komplett vom isolierenden Werkstoff des Trägerbauteils umgeben. Vorzugsweise werden die Anschlussleitungen bei der Herstellung des Trägerbauteils im Kunststoff-Spritzgießverfahren unmittelbar umspritzt. Auch ein vorgeformtes Drahtbauteil, wie in Figur 1 gezeigt, kann alternativ zu dem gezeigten Stanz-/Biegeteil zum Einsatz kommen.

Weiterhin zeigt das Ausführungsbeispiel in Figur 2 unterschiedliche Ausführungen der Kontaktstellen. Zur Kontaktierung des Elektromotors 1, hier an den Kontaktstellen der zwischengeschalteten elektrischen Drosselbauteile, sind hier an Enden der Anschlussleitungen unmittelbar angeformte Crimpkontakte 3.4 vorgesehen. Im Unterschied dazu sind zur Kontaktierung externer Anschlüsse hier Steckkontakte 3.5 vorgesehen. Diese Steckkontakte 3.5 sind umgeben von einer Ausformung des Trägerbauteils, die eine Aufnahme 2.6 für einen Stecker oder Gegenstecker bildet.

Zusätzlich sind weitere Ausführungen für weitere Kontaktstellen 3.6 der Anschlussleitungen dargestellt.
Ähnlich der Drahtschleife (Massekontakt 3.3) in Figur 1 ist hier eine Schleife des Stanz-/Biegeteils in den Innenbereich des Trägerbauteils 2.1 geführt und nicht von isolierendem Ma terial des Trägerbauteils umgeben. Diese Schleife bildet den Massekontakt 3.3.

Zur Aufnahme eines zusätzlichen elektrischen Bauteils 4 und zu dessen elektrischer Kontaktierung mit den Anschlussleitungen 3 sind weitere Kontaktstellen 3.6 und Ausformungen 2.7 am Trägerbauteil 2.1 vorgesehen. Das elektrische Bauteil 4 steht hier in Vertretung beliebiger elektrischer Bauelemente oder auch ganzer elektronischer Baugruppen sowie integrierter Schaltkreise, die zum Beispiel zur Ansteuerung, Absicherung, Entstörung oder Überwachung des Elektromotors dienen. Die zusätzlichen Ausformungen 2.7 des Trägerbauteils 2.1 können mannigfaltige Gestalt annehmen und zum Beispiel als mechanische Halterung für elektrische Bauteile 4 mittels Rastverbindung ausgebildet sein.

Durch Gestaltung der Ausformungen 2.7, als die Elektronik umgebendes Gebilde mit einem beweglichen Deckel, der über ein sogenanntes Folienscharnier unmittelbar angespritzt wird, kann ein Gehäuse um das elektrische Bauteil herum ausgebildet werden, welches das elektrische Bauteil ganz oder teilweise umschließt.

Figur 3 zeigt ein Ausführungsbeispiel des Anschlussadapters 2 das nicht unter der Gegenstand der vorliegenden Ansprüche fällt, bei dem die Anschlussleitungen 3 als Leiterbahnen auf das Trägerbauteil aufgebracht sind. Zur Herstellung einer solchen Anschlussadapter-Ausführung können die Leiterbahnen beispielsweise als elektrisch leitfähige Folie auf ganzer Länge oder punktuell aufgeklebt oder aufkaschiert werden oder auch als leitfähige Schicht aufgalvanisiert werden. Die Formstabilität und Lagefixierung der Kontaktstellen wird hier allein durch die unterstützenden Ausformungen des Trägerbauteils gewährleistet.

Die Ausformungen des Trägerbauteils im Bereich der Kontaktstellen 3.8 sind in diesem Ausführungsbeispiel so gestaltet, dass bei Annäherung dieser Kontaktstellen an die zu kontak tierenden Motorkontakte 1.5 des Elektromotors 1 in Fügerichtung (in Pfeilrichtung) eine zentrierende Wirkung entsteht.

Auf diese Weise können innerhalb eines bestimmten Toleranzbereiches von ihrer Soll-Lage abweichende, zu verbindende Kontaktstellen bei gegenseitiger Annäherung während des Montagevorganges relativ zueinander zentriert werden.
Solche oder ähnlich ausgebildete Kontaktstellen können auch in Verbindung mit Anschlussleitungen aus Draht-Biegeteilen oder Stanz-Biegeteilen zum Einsatz kommen.

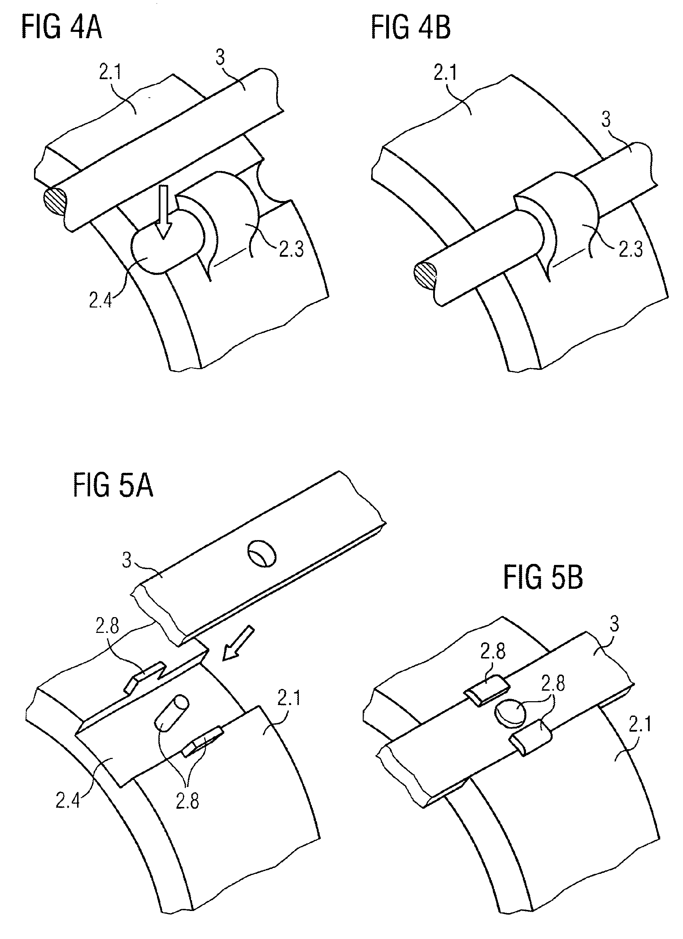

Figuren 4A und 4B zeigen einen Ausschnitt des Trägerbauteils 2.1 des Anschlussadapters 1 mit Raststützpunkten 2.3 und einer Leitungsnut 2.4 zusammen mit der Anschlussleitung 3, die als Draht-Ausschnitt dargestellt ist.
Die Figuren 4A und 4B zeigen die Anschlussleitung 3 vor bzw. nach dem Einrasten in den Raststützpunkt 2.3 und die Leitungsnut 2.4 (Fügerichtung entspricht Pfeilrichtung in Figur 4A). Es soll hier das Prinzip der Lagefixierung und der Leitungsführung am Trägerbauteil 2.1 durch Rastverbindung verdeutlicht werden. Selbstverständlich sind auch andere als die gezeigten, konstruktiv und/oder funktionell gleichwertige Ausführungen von Rast- oder Schnappverbindungen zwischen Trägerbauteil und Anschlussleitungen möglich, ebenso wie andere Ausprägungen der Anschlussleitung.

Figuren 5A und 5B zeigen, analog zu Figuren 4A und 4B, ein weiteres Prinzip der Lagefixierung der Anschlussleitung 3 am Trägerbauteil 2.1. Hier ist der Ausschnitt der Anschlussleitung 3 als Metallband dargestellt. Wiederum wird in den Figuren 5A und 5B der Zustand vor bzw. nach der Montage und Lagefixierung der Anschlussleitung 3 in der Leitungsnut 2.4 gezeigt. Die Montage der Anschlussleitung erfolgt in der in Figur 5A gezeigten Pfeilrichtung und die Lagefixierung erfolgt anschließend durch nachträgliche dauerhafte Materialumformung an dafür vorgesehenen Umformzapfen/Umformlaschen 2.8 oder ähnlichen Ausformungen am Trägerbauteil 2.1. Die Umformung kann zum Beispiel bei thermoplastischen Kunststoffen nachträglich durch beheizte Formstempel oder mit Hilfe von Ultraschall-Sonotroden erfolgen.

Figur 6 A zeigt ein vorgeformtes Stanz-Biegeteil das als Ganzes durch Umspritzen, Einrasten oder Material-Umformen mit dem Trägerbauteil lagefixiert verbunden werden kann.
Außer den Kontaktstellen, die als Schneid-Klemm-Kontakte 3.10, als Kontaktfahne 3.9 oder als Massekontakt 3.3 ausgeführt sind, weist die Anschlussleitung 3 eine Trennstelle 3.11 auf. Diese Trennstelle 3.11 verbindet zwei Teile der Anschlussleitung 3 und ermöglicht die vereinfachte Behandlung der beiden Teile der Anschlussleitung im Herstellungs- und Montageprozess. Nachdem die Anschlussleitung 3 als einstückiges Bauteil mit dem Trägerbauteil 2.1 verbunden wurde, wird die Trennstelle 3.11 aufgetrennt und es entstehen zwei elektrisch gegeneinander isolierte Anschlussleitungen 3A und 3B, wie in Figur 6B dargestellt.

Figuren 7A und 7B zeigen in vergrößerter Darstellung den gekennzeichneten Ausschnitt VII aus Figur 2. Im Ausschnitt werden weitere Kontaktstellen 3.6, die in Verbindung mit einem elektrischen Bauteil 4 stehen, das wiederum von Ausformungen 2.6 des Trägerbauteils zusätzlich mechanisch gehalten wird, gezeigt.

Es werden verschiedene Ausprägungen der Kontaktstellen 3.6 bei mit Trägerbauteil-Werkstoff umspritzten Anschlussleitungen dargestellt. Freie Kontaktstellen 3.6 werden erzeugt, wie in Figur 7A dargestellt, durch Aussparungen im isolierenden Trägerbauteil-Werkstoff in Bereichen der darin verlaufenden Anschlussleitungen. Diese Aussparungen können sich je nach Bedarf auf der Innenseite und/oder der Außenseite des Trägerbauteils befinden.

Freie Kontaktstellen entstehen ebenso dadurch, dass an definierten Stellen die Anschlussleitung aus dem sie umgebenden Trägerbauteil-Werkstoff nach innen oder außen hervorragt, wie in Figur 7B dargestellt. Hier weisen die Kontaktstellen 3.6 zusätzlich zentrierend wirkende Ausformungen 3.8 auf.

Der Werkstoff und die Dimensionierung der Anschlussleitungen 3 werden so gewählt, dass die Anschlussleitungen 3 die auf vorgegebener Länge aus dem Trägerbauteil 2.1 hervorragen ihre Geometrie formstabil beibehalten und so Positionsstabilität der Kontaktstellen gewährleisten.

Stabilität im Sinne von Form- oder Positionsstabilität sowie Lagefixierung bei mehreren in mechanischer Verbindung stehender Bauteile wird hier so aufgefasst, dass durch normale zu erwartende Belastungen des Bauteils oder der Baugruppe während der Herstellung und Weiterverarbeitung, sowie im erwartungsgemäßen Betrieb keine unerwünschten bleibenden Verformungen an den Bauteilen sowie Positions- oder Lageabweichungen zueinander auftreten.
Zu den möglichen Belastungen zählen beispielsweise auch Lagerung und Transport als Schüttgut in Kisten oder Handhabungsvorgänge während der Montage

Positionsstabilität der Kontaktstellen ist beispielsweise gegeben, wenn die Kontaktstellen, die gegebenenfalls aus dem Trägerbauteil hervorragen, durch Unterstützung des Trägerbauteils oder durch eigene Formstabilität der Anschlussleitung 3 die Relativposition zum Trägerbauteil 2.1, bei dem selbst auch Formstabilität vorausgesetzt wird, stabil beibehalten.

## Patentansprüche

1. Anschlussadapter für einen Elektromotor zum Antrieb von Hilfsaggregaten in der Automobiltechnik, mit
- einem Trägerbauteil (2.1) aus elektrisch isolierendem Werkstoff, welches ein Metallgehäuse des Elektromotors (1) zumindest teilweise radial umfasst und den Elektromotor (1) form- und/oder kraftschlüssig lagefixiert aufnimmt und mit
- mindestens einer im oder am Trägerbauteil (2.1) befestigten elektrischen Anschlussleitung (3) mit lagefixierten Kontaktstellen (3.1, 3.2, 3.3), zum Kontaktieren des Elektromotors (1) einerseits und zum Kontaktieren externer elektrischer Anschlüsse andererseits, wobei die elektrische Anschlussleitung (3) aus
- einem vorgeformten formstabilen Stanz-Biegeteil oder
- einem vorgeformten formstabilen Metalldraht hergestellt ist.
**dadurch gekennzeichnet,**
**dass** eine dieser Anschlussleitungen (3) sowohl mit einem Motorkontakt (1.5) einer Bürstenanordnung des Elektromotors als auch über eine weitere Kontaktstelle (3.3) mit dem Metallgehäuse (1.1) des Elektromotors (1) unmittelbar in parallelen elektrischen Kontakt steht,wobei ein zur Herstellung des elektrischen Kontaktes erforderlicher Kontaktdruck unter Nutzung der elastischen Verformbarkeit des Trägerbauteils und der Anschlussleitung erzeugt ist.

2. Anschlussadapter nach Anspruch 1, **dadurch gekennzeichnet, dass** die elektrische Anschlussleitung (3) derart in Rast-Stützpunkte (2.3) des Trägerbauteils (2.1) eingerastet sind, dass die Kontaktstellen (3.1, 3.2, 3.3, 3.6) zum Motorgehäuse hin oder vom Motorgehäuse weg zum Kontaktieren zugänglich sind und insbesondere aus dem isolierenden Umgebungsmaterial des Trägerbauteils (2.1) hervorragen.

3. Anschlussadapter nach Anspruch 1, **dadurch gekennzeichnet, dass** die elektrische Anschlussleitung (3) derart in das Material des Trägerbauteils (2.1) durch Material-Umformung zumindest teilweise eingebettet oder längs Ihrer Erstreckung vom Material des Trägerbauteils (2.1)elektrisch isolierend umschlossen ist, dass die Kontaktstellen (3.1, 3.2, 3.3, 3.6) zum Motorgehäuse hin oder vom Motorgehäuse weg zum Kontaktieren zugänglich sind und insbesondere aus dem isolierenden Umgebungsmaterial des Trägerbauteils (2.1) hervorragen.

4. Anschlussadapter nach einem der vorgehenden Ansprüche, **dadurch gekennzeichnet, dass** mindestens eine Kontaktstelle der elektrischen Anschlussleitung (3) einen Löt- oder Schweißstützpunkt (3.1, 3.2, 3.6) oder einen Steckkontakt (3.5) oder eine Kontaktfahne (3.9) oder einen Crimpkontakt (3.4) oder einen Federkontakt (3.3) aufweist.

5. Anschlussadapter nach einem der vorgehenden Ansprüche, **dadurch gekennzeichnet, dass** mindestens eine Kontaktstelle der elektrischen Anschlussleitung (3) eine zentrierend wirkende Ausformung (3.8) oder einen Schneid-Klemm-Kontakt (3.10) aufweist.

6. Anschlussadapter nach einem der vorgehenden Ansprüche, **dadurch gekennzeichnet, dass** zumindest eine in Bezug auf den Anschlussadapter (2) positionsstabile Kontaktstelle (3.2, 3.3) der Anschlussleitung (3) und eine korrespondierende, in Bezug auf den Elektromotor (1) positionsstabile Kontaktstelle (3.2, 3.3) des Elektromotors (1), bezogen auf die Endmontagelage des Anschlussadapters (2) gegenüber dem Elektromotor (1) die gleiche räumliche Position einnehmen, so dass durch die Montage des Anschlussadapters (2) mit dem Elektromotor (1) der elektrische Kontakt zwangsweise erzeugt wird.

7. Anschlussadapter nach einem der vorgehenden Ansprüche, **dadurch gekennzeichnet, dass** mindestens ein elektrisches Bauteil (4) mit wenigstens einer Kontaktstelle (3.6) der elektrischen Anschlussleitung (3) in elektrisch leitender Verbindung steht.

8. Anschlussadapter nach Anspruch 7, **dadurch gekennzeichnet, dass** das mindestens eine elektrische Bauteil (4) in einer Ausformung (2.7) des Anschlussadapters befestigt oder zumindest teilweise von Teilen des Trägerbauteils (2.1) abgedeckt ist.

9. Anschlussadapter nach einem der vorgehenden Ansprüche, **dadurch gekennzeichnet, dass** eine Ausformung des Anschlussadapters im Bereich mindestens einer Kontaktstelle (3.1) der elektrischen Anschlussleitung (3) eine Aufnahme (2.6) für einen Stecker oder Gegenstecker bildet.

10. Anschlussadapter nach einem der vorgehenden Ansprüche, **dadurch gekennzeichnet, dass** mindestens eine am Anschlussadapter (2) lagefixierte Anschlussleitung (3) durch nachträgliches Auf- oder Abtrennen mindestens einer Trennstelle (3.11) unterbrochen ist und so mehrere elektrisch voneinander isolierte Anschlussleitungen (3) geschaffen sind.

11. Anschlussadapter nach einem der vorgehenden Ansprüche, **dadurch gekennzeichnet, dass** das Trägerbauteil (2.1) unmittelbar angeformte Befestigungsmittel (2.2) auf der vom Elektromotor (1) abgewandten Oberfläche aufweist.

## Claims

1. Connection adaptor for an electric motor for driving auxiliary power engines within automotive engineering, with
- a carrier assembly (2.1) made of electrically insulating material, which comprises a metal housing of the electric motor (1) at least partially radial and accommodates the electric motor (1) in a fixed position in a form-fitted or force-fitted manner and with
- at least one electrical connecting line (3) fastened in or on the carrier assembly (2.1), said electrical connecting line having fixed-position contact points (3.1, 3.2, 3.3) for contacting the electric motor (1) on the one hand and for contacting external electrical connections on the other hand, with the electrical connecting line (3) being manufactured from
- a preformed inherently stable punching bending component or
- a preformed inherently stable metal wire
**characterised in that**
one of these connecting lines (3) is in direct parallel electrical contact both with an engine contact (1.5) of a brush arrangement of the electric motor as well as also via a further contact point (3.3) with the metal housing (1.1) of the electric motor (1), with a contact pressure required to establish the electrical contact being generated using the elastic formability of the carrier assembly and the connecting line.

2. Connection adaptor according to claim 1, **characterised in that** the electrical connecting line (3) is engaged in the grid-support points (2.3) of the carrier assembly (2.1) such that the contact points (3.1, 3.2, 3.3, 3.6) are accessible at the motor housing or from the motor housing for contacting purposes, and protrude in particular out of the insulating ambient material of the carrier assembly (2.1).

3. Connection adaptor according to claim 1, **characterised in that** the electrical connecting line (3) is at least partially embedded in the material of the carrier assembly (2.1) by means of material deformation or is electrically insulatingly enclosed along its extension by the material of the carrier assembly (2.1) such that the contact points (3.1, 3.2, 3.3, 3.6) are accessible at the motor housing or from the motor housing for the purpose of contacting, and protrude in particular out of the insulating ambient material of the carrier assembly (2.1).

4. Connection adaptor according to one of the preceding claims, **characterised in that** at least one contact point of the electrical connecting line (3) comprises a solder or weld base (3.1, 3.2, 3.6) or a plug contact (3.5) or a contact flag (3.9) or a crimp contact (3.4) or a spring contact (3.3).

5. Connection adaptor according to one of the preceding claims, **characterised in that** at least one contact point of the electrical connecting line (3) comprises a centrally active moulding (3.8) or a slitter clamp contact (3.10).

6. Connection adaptor according to one of the preceding claims, **characterised in that** at least one contact point (3.2, 3.3) of the connecting line (3) which can be positioned in a stable manner with regard to the connection adaptor (2) and a corresponding contact point (3.2, 3.3) of the electric motor which can be positioned in a stable manner with regard to the electric motor (1) take up the same spatial position relating to the final assembly position of the connection adaptor (2) compared with the electric motor (1), so that the electrical contact is coercively generated by assembling the connection adaptor (2) with the electric motor (1).

7. Connection adaptor according to one of the preceding claims, **characterised in that** at least one electrical component (4) is in an electrically conductive connection with at least one contact point (3.6) of the electrical connecting line (3).

8. Connection adaptor according to claim 7, **characterised in that** at least one electrical component (4) is mounted in a moulding (2.7) of the connection adaptor or is at least partially covered by components of the carrier assembly (2.1).

9. Connection adaptor according to one of the preceding claims, **characterised in that** a moulding of the connection adaptor in the region of at least one contact point (3.1) of the electrical connecting line (3) forms a receptacle (2.6) for a plug or a mating plug.

10. Connection adaptor according to one of the preceding claims, **characterised in that** at least one connecting line (3) fixed to the connection adaptor (2) is interrupted by a subsequent disconnection or separation of at least one cut-off point (3.11) thereby creating a number of connecting lines (3) which are electrically insulated from one another.

11. Connection adaptor according to one of the preceding claims, **characterised in that** the carrier assembly (2.1) comprises directly moulded fastening means (2.2) on the surface opposite to the electric motor (1).

## Revendications

1. Adaptateur de raccordement pour un moteur électrique destiné à l'entraînement de groupes auxiliaires dans la technique automobile, comprenant
- un élément de support (2.1) en matière électriquement isolante qui entoure radialement une carcasse du moteur électrique (1) au moins partiellement et qui loge le moteur électrique (1) à position fixe en engagement de forme et/ou de force, et
- au moins une ligne de connexion électrique (3) fixée dans ou sur l'élément de support (2.1) et présentant des points de contact (3.1, 3.2, 3.3) à position fixe pour la connexion du moteur électrique (1), d'une part, et de raccordements électriques externes, d'autre part, la ligne de connexion électrique (3) étant fabriquée
- à partir d'une pièce estampée et pliée indéformable et préformée ou
- d'un fil métallique indéformable et préformé,
**caractérisé en ce qu'**une de ces lignes de raccordement électrique (3) est en contact électrique parallèle direct avec un contact de moteur (1.5) d'un système de balais du moteur électrique et également, via un autre point de contact (3.3), avec la carcasse métallique (1.1) du moteur électrique (1), une pression de contact nécessaire pour établir le contact électrique étant générée en utilisant la capacité de déformation élastique de l'élément de support et de la ligne de connexion.

2. Adaptateur de raccordement selon la revendication 1, **caractérisé en ce que** les lignes de raccordement électrique (3) sont encliquetées dans des points d'appui d'encliquetage (2.3) de l'élément de support (2.1) de telle manière que les points de contact (3.1, 3.2, 3.3, 3.6) menant à la carcasse de moteur ou en sortant sont accessibles pour l'établissement des contacts et dépassent en particulier du matériau isolant entourant l'élément de support (2.1).

3. Adaptateur de raccordement selon la revendication 1, **caractérisé en ce que** la ligne de connexion électrique (3) est noyée au moins partiellement dans le matériau de l'élément de support (2.1) par réformation du matériau, ou est enfermée sur sa longueur par le matériau de l'élément de support (2.1) de manière électriquement isolante, de façon à ce que les points de contact (3.1, 3.2, 3.3, 3.6) menant à la carcasse de moteur ou en sortant sont accessibles pour l'établissement des contacts et dépassent en particulier du matériau isolant entourant l'élément de support (2.1).

4. Adaptateur de raccordement selon l'une des revendications précédentes, **caractérisé en ce qu'**au moins un point de contact de la ligne de connexion électrique (3) comprend un point de support de soudage ou de brasage (3.1, 3.2, 3.6) ou un contact enfichable (3.5) ou une cosse de raccord (3.9) ou un raccord à crampon (3.4) ou un contact à ressort (3.3).

5. Adaptateur de raccordement selon l'une des revendications précédentes, **caractérisé en ce qu'**au moins un des points de contact de la ligne de connexion électrique (3) comprend une partie formée (3.8) à effet de centrage ou un contact de serrage autodénudant (3.10).

6. Adaptateur de raccordement selon l'une des revendications précédentes, **caractérisé en ce qu'**au moins un point de contact (3.2, 3.3) de la ligne de connexion (3), immobile par rapport à l'adaptateur de raccordement (2), et un point de contact correspondant (3.2, 3.3), immobile par rapport au moteur électrique (1), prennent la même position spatiale par rapport au moteur électrique (1), le tout se référant à la position de montage final de l'adaptateur de raccordement (2) par rapport au moteur électrique (1), de sorte que l'assemblage de l'adaptateur de raccordement (2) avec le moteur électrique (1) produit forcément le contact électrique.

7. Adaptateur de raccordement selon l'une des revendications précédentes, **caractérisé en ce qu'**au moins un composant électrique (4) est en connexion électriquement conductrice avec au moins un point de contact (3.6) de la ligne de connexion électrique (3).

8. Adaptateur de raccordement selon la revendication 7, **caractérisé en ce que** le au moins un composant électrique (4) est fixé dans une partie formée (2.7) de l'adaptateur de raccordement, ou est au moins partiellement recouvert de parties de l'élément de support (2.1).

9. Adaptateur de raccordement selon l'une des revendications précédentes, **caractérisé en ce qu'**une partie formée de l'adaptateur de raccordement située dans la région d'au moins un point de contact (3.1) de la ligne de connexion électrique (3) forme un logement (2.6) pour une fiche ou une contrefiche.

10. Adaptateur de raccordement selon l'une des revendications précédentes, **caractérisé en ce qu'**au moins une ligne de connexion (3) disposée en position fixe sur l'adaptateur de raccordement (2), est interrompue par au moins un point de coupure (3.11) obtenu par une section ou une séparation ultérieures, créant ainsi plusieurs lignes de raccordement (3) électriquement isolées les unes des autres.

11. Adaptateur de raccordement selon l'une des revendications précédentes, **caractérisé en ce que** l'élément de support (2.1) comprend des moyens de fixation (2.2) directement formés sur la surface opposée au moteur électrique (1).
